(19) Europäisches Patentamt
European Patent Office
Office européen des brevets

(11) **EP 4 779 688 A1**

(12) **EUROPEAN PATENT APPLICATION**
published in accordance with Art. 153(4) EPC

(43) Date of publication:
**22.07.2026 Bulletin 2026/30**

(21) Application number: **24869415.0**

(22) Date of filing: **01.11.2024**

(51) International Patent Classification (IPC):
**H01L 23/427** (2006.01)  **H01L 23/367** (2006.01)
**F28F 13/18** (2006.01)  **F28F 13/06** (2006.01)

(52) Cooperative Patent Classification (CPC):
**F28F 13/187; F28D 15/046; F28F 2245/02;
F28F 2245/04**

(86) International application number:
**PCT/CN2024/129228**

(87) International publication number:
**WO 2026/031368 (12.02.2026 Gazette 2026/07)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **06.08.2024 CN 202411077729**

(71) Applicant: **Huazhong University of Science and
Technology
Wuhan, Hubei 430074 (CN)**

(72) Inventors:
• **YANG, Ronggui
Wuhan, Hubei 430074 (CN)**
• **LI, Pengkun
Wuhan, Hubei 430074 (CN)**
• **LIU, Xiuliang
Wuhan, Hubei 430074 (CN)**

(74) Representative: **Straus, Alexander
2K Patentanwälte - München
Bajuwarenring 14
82041 Oberhaching (DE)**

(54) **SURFACE STRUCTURE FOR ENHANCED BOILING HEAT TRANSFER, AND MANUFACTURING METHOD THEREFOR**

(57)    The surface structure for enhancing boiling heat transfer disclosed in the present disclosure has first pores for bubble departure, micro-structured features for promoting bubble nucleation, and second pores for liquid wicking. The pore size of the first pores is greater than that of the second pores, and the pore size of the second pores is greater than the width of the micro-structured features. There are multiple first pores, micro-structured features, and second pores. In the surface structure for enhancing boiling heat transfer disclosed in the present disclosure, the arrangement of multiple micro-structured features may increase effective bubble nucleation sites for boiling, which may promote the initiation of boiling. The arrangement of multiple first pores may provide low-resistance vapor flow channels, allowing bubbles to detach more rapidly. The direction of bubble departure is consistent with the direction of heat dissipation, which may improve heat transfer efficiency. The arrangement of multiple first pores separates the vapor and liquid flows, minimizing interference between bubble departure and liquid wicking, thereby enhancing heat transfer performance. The present disclosure also discloses a method for fabricating the surface structure for enhancing boiling heat transfer.

FIG. 1

## Description

## [Technical Field]

The present disclosure relates to the field of heat transfer technology, more specifically, to a surface structure for enhancing boiling heat transfer and a manufacturing method thereof.

## [Description of Related Art]

With the development of integration and miniaturization of electronic components, many high-power energy systems, such as radars, lasers, light-emitting diodes, and microprocessors, require dissipation of enormous amounts of heat in limited spaces. Compared to single-phase heat convection cooling methods (such as fans), liquid-vapor phase change cooling technologies (such as capillary evaporation and boiling) fully utilize the latent heat of liquid-vapor phase change, enabling efficient heat dissipation at low surface temperatures. Therefore, liquid-vapor phase change cooling methods are receiving increasing attention in the design of heat dissipation systems.

The critical heat flux (CHF) of capillary evaporation is mainly enhanced by increasing the thickness of the liquid film to improve the liquid wicking capacity of the surface. However, increasing the thickness of the capillary wicking structure significantly increases the thermal resistance, thereby reducing the heat transfer coefficient (HTC) of the surface. In recent years, liquid film boiling where vapor bubbles are generated within a thicker liquid film significantly expand the liquid-vapor evaporation interface and improve the heat transfer coefficient, resolving the conflicting requirements between increasing the CHF and improving the HTC. To enhance the heat transfer performance of liquid-vapor phase change, researchers have developed high-wickability surface structures to improve the liquid transport capacity through the surface. However, these surface structures only show outstanding performance in enhancing liquid transport.

Therefore, developing a surface structure to achieve synergistic enhancement of liquid transport and bubble departure for improving the boiling heat transfer efficiency and performance, has become an urgent technical problem for those skilled in the field to solve.

## [SUMMARY]

Embodiments of the present disclosure include a surface structure for enhancing boiling heat transfer, thus achieving synergistic enhancement of liquid film transport, bubble nucleation, and bubble departure, thereby improving the boiling heat transfer efficiency and performance.

Manufacturing methods are also disclosed for the aforementioned surface structure for enhancing boiling heat transfer.

To achieve the above objectives, the present disclosure provides the following technical solutions:

Some embodiments include a surface structure for enhancing boiling heat transfer, wherein the surface structure for enhancing boiling heat transfer is combined with a heat transfer substrate and has a plurality of first pores for bubble departure, a plurality of micro-structured features for promoting bubble nucleation, and a plurality of second pores for improving liquid wicking.

The pore size of the first pore is greater than the pore size of the second pores, and the pore size of the second pores is greater than the width of the micro-structured features.

The quantities of the first pores, microscale structures, and second pores are all multiple.

In some embodiments, the arrangement of the first pores comprises an array arrangement or a random arrangement.

In some embodiments, the array arrangement of the first pores comprises a square array, a rectangular array, a circular array, or a hexagonal array arrangement.

In some embodiments, the cross-sectional shape of the first pores may at least include one of triangle, rectangle, rhombus, pentagon, hexagon, circle, ellipse, and star; and/or, the type of micro-structured feature may at least include one of a cavity, a pore, or a gap.

In some embodiments, the first pores may be constructed as blind-hole pores on the surface structure for enhancing boiling heat transfer; or,

The first pores may be constructed as through-hole pores on the surface structure for enhancing boiling heat transfer; or,

Some of the first pores may be constructed as blind-hole pores on the surface structure for enhancing boiling heat transfer, while the remaining first pores may be constructed as through-hole pores on the surface structure for enhancing boiling heat transfer.

In some embodiments, the first pores may at least include one of gradually expanding pores, gradually narrowing pores, and uniform pores.

In some embodiments, the pore size of the first pores may be $10\mu m$ to $1000\mu m$, and the spacing between two adjacent first pores may be $15\mu m$ to $5000\mu m$; and/or,

The height of the micro-structured features may be $0.1\mu m$ to $20\mu m$, and the aspect ratio may be greater than 2.

In some embodiments, the pore size of the second pores may range from $10\mu m$ to $500\mu m$, and the diameter or width of the skeleton of the surface structure for enhancing boiling heat transfer may range from $20\mu m$ to $100\mu m$.

In some embodiments, the surface structure for enhancing boiling heat transfer may include one or more of multi-layer woven mesh, sintered powder, metal foam, grooves, micro-pillar arrays, and electrodeposited porous structures.

In some embodiments, the surface structure for enhancing boiling heat transfer is made of a material of copper, brass, bronze, aluminum, silicon, titanium, and stainless steel; and/or,

The material for preparing the heat transfer substrate may include one of copper, brass, bronze, aluminum, silicon, titanium, and stainless steel.

Some embodiments may include a method of fabricating a surface structure for enhancing boiling heat transfer, comprising:

fabricating a uniform surface structure, wherein the uniform surface structure includes second pores;
preparing first pores, and perforating the uniform surface structure to form a first surface structure with the first pores;
combining the first surface structure with the heat transfer substrate to form a combination of the two;
forming micro-structured features by treating the surface of the combination of the heat transfer substrate and the first surface structure using an etching method to form a plurality of micro-structured features on the first surface structure and the heat transfer substrate; and
performing hydrophilic or hydrophobic surface modification treatment on at least a portion of the micro-structured features.

In some embodiments, the method for fabricating the surface structure may include a pretreatment step before the step of combining the first surface structure with the heat transfer substrate, comprising:

polishing the surface of the heat transfer substrate; and
cleaning the polished heat transfer substrate and the first surface structure.

In some embodiments, the etching method at least includes one of chemical etching, sandblasting, electroplating, and mechanical processing.

In some embodiments, the method for hydrophilic or hydrophobic surface modification treatment at least includes one of plasma modification, surface coating technique, and surface grafting modification.

From the above technical solution, it can be seen that, in the surface structure for enhancing boiling heat transfer disclosed in the present disclosure, the second pores are configured for liquid wicking, and a plurality of micro-structured features may increase the effective bubble nucleation sites for boiling, facilitating the incipience of boiling. A plurality of first pores may provide low-resistance vapor flow passages, allowing bubbles to departure more rapidly. The direction of bubble departure is consistent with the direction of heat dissipation, which may improve heat transfer efficiency. A plurality of first pores may separate the liquid-vapor flow pathway, minimizing the interference between bubble departure and liquid wicking, thereby enhancing the heat transfer performance.

The method for fabricating the surface structure for enhancing boiling heat transfer disclosed in the present disclosure has simple steps, reasonable design, easy implementation, high operability, and is convenient for scale manufacturing, possessing important practical value and significance for promotion.

**[BRIEF DESCRIPTION OF THE DRAWINGS]**

To more clearly illustrate the technical solutions in the embodiments of the present disclosure or in the related art, a brief introduction will be given below to the drawings that need to be used in the description of the embodiments or the prior art. Clearly, the drawings described below are only some embodiments of the present disclosure. For those skilled in the art, other drawings may be obtained based on these drawings without creative effort.

FIG. 1 shows a diagrammatic representation of liquid film boiling on the surface structure for enhancing boiling heat transfer disclosed in the embodiments of the present disclosure.
FIG. 2 shows SEM images in top view and side cross-sectional view of the micro-perforated copper mesh structure with a square array arrangement of the first pores, and SEM images of the micropore structure on the copper wire, as disclosed in the embodiments of the present disclosure.
FIG. 3 shows a top-view SEM image of the micro-perforated copper mesh with a hexagonal array arrangement of the first pores, and a diagrammatic representation of the hexagonal array, as disclosed in the embodiments of the present disclosure.
FIG. 4 shows a top-view SEM image of the micro-perforated copper powder with a square array arrangement of the first pores, as disclosed in the embodiments of the present disclosure.
FIG. 5 shows a top-view SEM image of the micro-perforated copper foam with a square array arrangement of the first pores, as disclosed in the embodiments of the present disclosure.
FIG. 6A is a photograph of the liquid film boiling experimental setup disclosed in the embodiments of the present disclosure.
FIG. 6B is a diagrammatic representation of the liquid film boiling experimental setup disclosed in the embodiments of the present disclosure.
FIG. 6C is a diagrammatic representation showing the positions of thermocouples inside the heating block in the liquid film boiling experimental setup disclosed in the embodiments of the present disclosure.
FIG. 7A is an optical photograph of the experimental apparatus for measuring the permeability in the through-thickness direction of the surface structure, as disclosed in the embodiments of the present disclosure.

FIG. 7B shows the viscous pressure difference in the through-thickness direction with varied water flow velocities for micro-perforated copper mesh with different perforation distances, as disclosed in the embodiments of the present disclosure.

FIG. 7C shows the viscous pressure difference in the through-thickness direction with varied water flow velocities for different types of micro-uniform structures, as disclosed in the embodiments of the present disclosure.

FIG. 7D shows the viscous pressure difference in the through-thickness direction with varied water flow velocities for different micro-perforated surface structures, as disclosed in the embodiments of the present disclosure.

FIG. 8A shows the measurement results of permeability in the through-thickness direction of micro-perforated copper meshes with different perforation distances, as disclosed in the embodiments of the present disclosure.

FIG. 8B shows the measurement results of permeability in the through-thickness direction of different micro-uniform surface structures and micro-perforated surface structures, as disclosed in the embodiments of the present disclosure.

FIG. 9A shows the heat flux as a function of superheat for liquid film boiling on micro-perforated copper mesh with a square array arrangement of the first pores, as disclosed in the embodiments of the present disclosure.

FIG. 9B shows the measurement results of critical heat flux and the maximum heat transfer coefficient of liquid film boiling on micro-perforated copper meshes with square array and hexagonal array arrangements of the first pores, as disclosed in the embodiments of the present disclosure.

FIG. 10A shows a diagrammatic representation and two time-lapse optical photographs of liquid film boiling on the micro-perforated copper mesh with a hexagonal array arrangement of the first pores, and corresponding schematic views of bubble dynamics, as disclosed in the embodiments of the present disclosure.

FIG. 10B shows a diagrammatic representation and two time-lapse optical photographs of liquid film boiling on the micro-perforated copper mesh with a square array arrangement of the first pores, and corresponding schematic views of bubble dynamics, as disclosed in the embodiments of the present disclosure.

FIG. 11A shows a diagrammatic representation and three time-lapse optical photographs of liquid film boiling on the micro-uniform copper mesh, and corresponding schematic views of bubble dynamics, as disclosed in the embodiments of the present disclosure.

FIG. 11B shows a diagrammatic representation and three time-lapse optical photographs of liquid film boiling on the micro-perforated copper mesh with a perforation spacing of $1\,500\mu m$, and corresponding schematic views of bubble dynamics, as disclosed in the embodiments of the present disclosure.

FIG. 11C shows a diagrammatic representation and three time-lapse optical photographs of liquid film boiling on the micro-perforated copper mesh with a perforation spacing of $900\mu m$, and corresponding schematic views of bubble dynamics, as disclosed in the embodiments of the present disclosure.

FIG. 12A shows a quantitative analysis of the change in liquid film boiling area with heat flux on three test surface structures disclosed in the embodiments of the present disclosure.

FIG. 12B shows a quantitative analysis of the change in the bubble departure frequency with heat flux on three test surface structures disclosed in the embodiments of the present disclosure.

FIG. 13 shows a comparison of liquid film boiling heat transfer performance on three test surface structures disclosed in the embodiments of the present disclosure.

FIG. 14 shows a comparison of liquid film boiling heat transfer performance of plain uniform copper mesh, micro-uniform copper mesh, and micro-perforated copper mesh with different heating areas, as disclosed in the embodiments of the present disclosure.

FIG. 15 shows a flowchart of a method for fabricating a surface structure for enhancing boiling heat transfer, as disclosed in the embodiments of the present disclosure.

Wherein, 10 is a heater, A is a bubble;

101 represents first pores, 102 represents microstructured features, 103 represents second pores, 110 represents a heat transfer substrate; 210 represents a liquid film boiling chamber, 211 represents an viewing window, 220 represents a high-speed camera, 230 represents a cooling circulation loop, 231 represents a condenser, 232 represents a chiller, 240 represents a heating system, 241 represents a DC power supply, 242 represents a cylindrical heater, 243 represents a heating block, 244 represents an insulation material, 250 represents a data measurement system, 251 represents thermocouples, 252 represents a pressure transducer, 253 represents a data acquisition system, 260 represents a vacuum pump.

## [DESCRIPTION OF THE EMBODIMENTS]

The focus of the present disclosure lies in disclosing a surface structure for enhancing boiling heat transfer, so as to achieve synergistic enhancement of liquid film transport and bubble departure, thereby improving the heat transfer efficiency and heat transfer performance of boiling.

Another focus of the present disclosure lies in disclosing a method for fabricating the aforementioned surface structure for enhancing boiling heat transfer.

The following description will clearly and completely describe the technical solutions in the embodiments of the present disclosure in conjunction with the accompanying drawings of the embodiments of the present disclosure. Clearly, the described embodiments are only a part of the embodiments of the present disclosure, not all of the embodiments. Based on the embodiments in the present disclosure, all other embodiments obtained by those skilled in the art without creative efforts are within the scope of protection of the present disclosure.

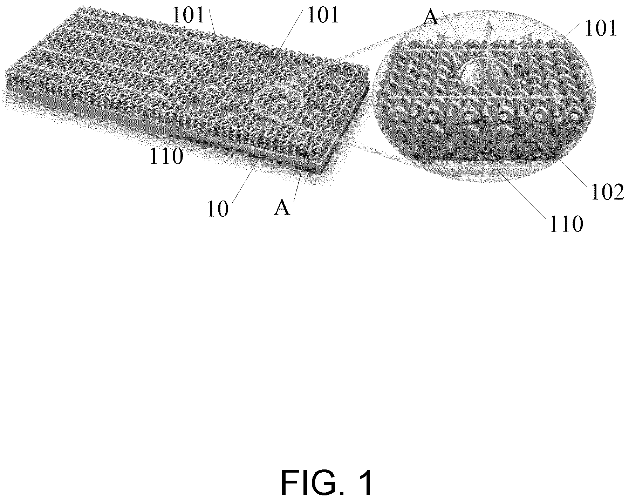

As shown in FIG. 1, the embodiment of the present disclosure discloses a surface structure for enhancing boiling heat transfer, combined with a heat transfer substrate 110, and having a plurality of first pores 101 for bubble departure, a plurality of micro-structured features 102 for facilitating bubble nucleation, and a plurality of second pores 103 for liquid wicking. It should be noted that the material of the surface structure for enhancing boiling heat transfer may be the same as or different from the material of the heat transfer substrate 110.

The quantity of the first pores 101, microscale structures 102, and second pores 103 are all multiple, and they are disposed at intervals respectively. The pore size of the first pores 101 is greater than the pore size of the second pores 103, and the pore size of the second pores 103 is greater than the width of the micro-structured features 102.

Taking the copper mesh as an example, in order to easily distinguish between the structure with the first pores 101 and the structure without the first pores 101, the copper mesh with the first pores 101, micro-structured features 102, and second pores 103 is called a micro-perforated copper mesh, and the copper mesh with only the second pores 103 is called a plain uniform copper mesh. The naming rules for other structures are the same. In the following, micro-perforated copper foam refers to the copper foam with the first pores 101, micro-structured features 102, and second pores 103; plain uniform copper foam refers to the copper foam with only the second pores 103; micro-perforated copper powder refers to the copper powder with the first pores 101, micro-structured features 102, and second pores 103; and plain uniform copper powder refers to the copper powder with only the second pores 103.

The copper mesh includes a multi-layer mesh, with each single layer composed of multiple copper wires. The second pores 103 refer to the pores formed between the copper wires in each single layer mesh and between layers. The first pores 101 are formed by perforating the copper mesh. As shown in FIG. 1, the first pores 101 penetrate through the copper wires and the second pores 103. Multiple first pores 101 are arranged at intervals, forming a low-resistance vapor flow channel for bubble departure.

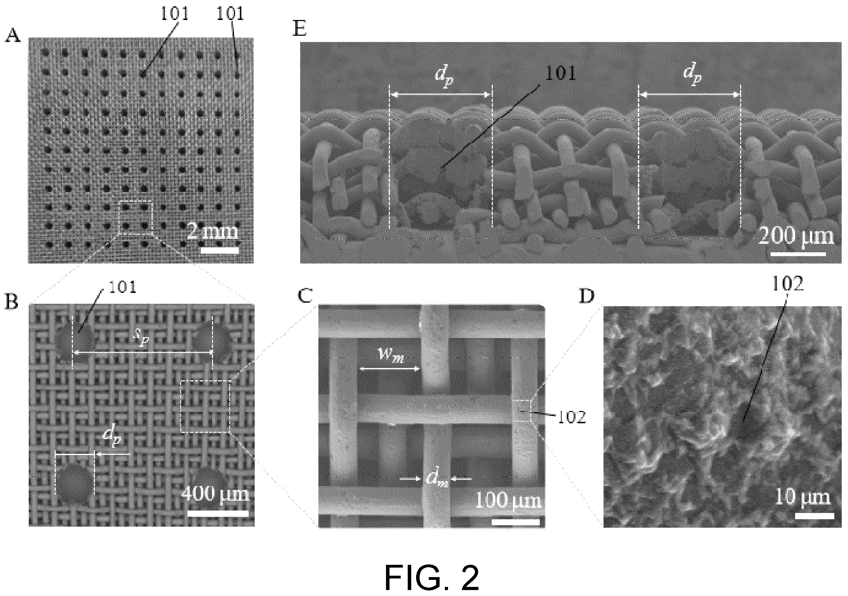

Multiple first pores 101 may be uniformly arranged, as shown in FIG. 2A, or non-uniformly arranged. The cross-sectional shape of the first pores 101 may at least include one of triangle, rectangle, diamond, pentagon, hexagon, circle, ellipse, and star, or may be other shapes. The micro-structured features 102 are disposed on the solid skeleton of the surface structure for enhancing boiling heat transfer, as shown in FIG. 2C and FIG. 2D. The micro-structured features 102 shown in the figure are disposed on every exposed copper wire. FIG. 2D is an enlarged SEM image of the micro-structured features 102 shown in FIG. 2C. The number in the lower right corner of the figure is the scale bar, which is only an example and cannot be used as a limitation. The type of micro-structured features 102 shown in the figure is a cavity, which may be circular, elliptical, or square in shape, with no specific limitation on the specific shape. The type of micro-structured features 102 may also be other types such as pore and gap.

FIG. 1 takes liquid film boiling an example of to illustrate the benefits of the surface structure for boiling heat transfer. The left image includes a heater 10, which provides heat for the liquid film boiling. Above the heater 10 is the surface structure for enhancing boiling heat transfer disclosed in the embodiments of the present disclosure. A portion without the heater 10 is a uniform surface structure with only the second pores 103, through which liquid is wicked (the arrow in the left figure indicates the direction of liquid flow) to supply liquid to the surface structure for enhancing boiling heat transfer disclosed in the embodiments of the present disclosure for liquid film boiling to dissipate heat. As shown in the right figure of FIG. 1, the arrangement of multiple micro-structured features 102 may increase effective bubble nucleation sites for boiling, facilitating the incipience of liquid film boiling. The arrangement of micro-structured features 102 may also improve the surface wettability, providing permeable liquid passages with high capillary force and low-resistance, allowing liquid transport to rewet the heated surface. The arrangement of multiple first pores 101 provides low-resistance vapor flow passages, enabling bubbles to quickly departure from the surface structure for enhancing boiling heat transfer. The right figure in FIG. 1 shows a schematic of bubble A departing from the first pores 101. The horizontal arrows in the right figure indicate liquid film wicking, while the vertical arrows indicate the direction of bubble A departure. The direction of bubble A detachment is consistent with the heat dissipation direction, which may improve heat transfer efficiency. The arrangement of multiple first pores 101 and micro-structured features 102 separates the vapor and liquid flow pathways, minimizing the interference between bubble departure and liquid wicking, thereby enhancing heat transfer performance of boiling. It should be noted that the embodiment of the present disclosure is not only applicable to liquid film boiling but also to pool boiling, flow boiling, spray cooling, and other heat transfer application scenarios.

In the surface structure for enhancing boiling heat transfer disclosed in the embodiments of the present disclosure, the arrangement of multiple first pores 101 may at least include one of an array arrangement and a random arrangement. The array arrangement may at least include one of a square array, a rectangular array, a circular array, and a hexagonal array arrangement, or may be other array arrangements.

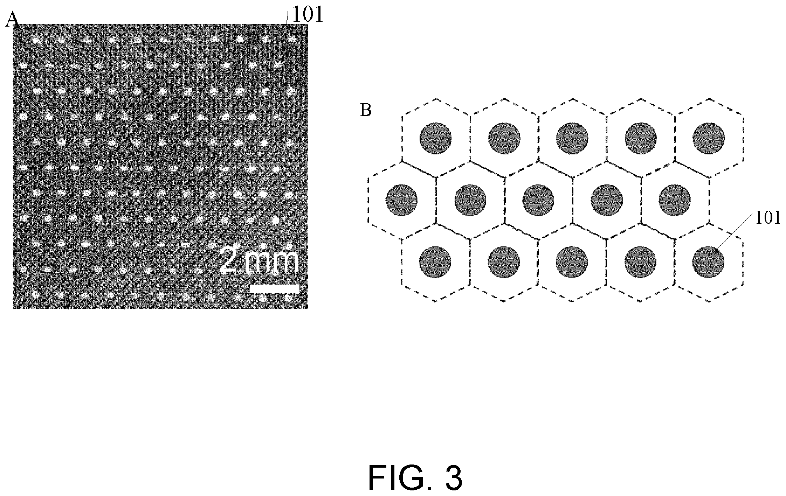

In some embodiments, the arrangement of multiple first pores 101 may be an array arrangement including square array (as shown in FIG. 2A) and hexagonal array (as shown in FIG. 3). In the experiments described below, the array arrangement of the first pores 101 includes two types: square array and hexagonal array.

FIG. 2A shows a square array, where the array shown is 11×11, i.e., the array has 11 rows and 11 columns. For ease of explanation, multiple first pores 101 arranged horizontally on the same straight line are referred to as a traverse unit. The square array means that the first pores 101 in corresponding positions of multiple traverse units arranged vertically are all on the same straight line. For each traverse unit, from left to right, there are eleven first pores 101 in sequence. For all traverse units, the centers of the first first pores 101 are on the same straight line, the centers of the second first pores 101 are on the same straight line, and the centers of the eleventh first pores 101 are on the same straight line. The positional relationships of other first pores 101 are the same as those of the aforementioned first pores 101, which will not be repeated here. It should be noted that the quantity of first pores 101 shown in the figure is only an example, and the specific quantity may be selected according to the actual scenario.

Based on the above embodiments, a hexagonal array refers to an arrangement where the area occupied by each of the first pores 101 is a regular hexagon, and these regular hexagons are connected in sequence, as shown in FIG. 3B. Alternatively, a hexagonal array may refer to an arrangement where the first pores 101 in corresponding positions of odd-numbered traverse units are on the same straight line, while the first pores 101 in corresponding positions of even-numbered traverse units are on the same straight line, as shown in FIG. 3A and FIG. 3B. Taking the first to sixth traverse units as an example, the centers of the first first pores 101 in the first, third, and fifth traverse units are on the same straight line, the centers of the second first pores 101 are on the same straight line, and the same applies to the first pores 101 in other positions, which will not be repeated here. The centers of the first first pores 101 in the second, fourth, and sixth traverse units are on the same straight line, the centers of the second first pores 101 are on the same straight line, and the same applies to the first pores 101 in other positions. It should be noted that the square array and hexagonal array mentioned here are just two specific schemes, and the specific array arrangement of multiple first pores 101 may also be in other ways.

In some embodiments, the first pores 101 may be constructed as blind-hole pores on the surface structure; in other embodiments, the first pores 101 may be constructed as through-hole pores on the surface structure; in yet other embodiments, some of the first pores 101 may be constructed as blind-hole pores on the surface structure, while the remaining first pores 101 may be constructed as through-hole pores on the surface structure. As shown in FIG. 2E, which illustrates a side cross-sectional image of the first pores 101 disposed in a micro-perforated copper mesh as an example, the micro-perforated copper mesh includes multiple copper wires. From the figure, it can be seen that the first pores 101 penetrates multiple layers of copper wires (the solid skeleton of the mesh) and the second pores 103, i.e., the first pores 101 shown in the figure are through-hole pores on the surface structure. The blind-hole pores refer to first pores 101 that only penetrates some layers of copper wires and the second pores 103, without penetrating all layers of copper wires.

In the surface structure for enhancing boiling heat transfer disclosed in the embodiments of the present disclosure, the first pores 101 may at least include one of gradually expanding pores, gradually narrowing pores, and uniform pores. It should be noted that the term "gradually expanding" here refers to a gradual increase in the cross-sectional diameter of the first pores 101 along the axial direction of the first pores 101; "gradually narrowing" refers to a gradual decrease in the cross-sectional diameter of the first pores 101 along the axial direction of the first pores 101; and "uniform pore" refers to first pores 101 with the same cross-sectional diameter along the axial direction of the first pores 101.

In some embodiments, the pore size of the first pores 101 may be 10μm to 1000μm (as denoted by $d_p$ in FIG. 2B and FIG. 2E), the cross-sectional shape of the first pores 101 shown in the figure is circular, and the spacing between two adjacent first pores 101 (hereinafter referred to as pore spacing) may be 15μm to 5000μm; the height of the micro-structured features 102 may be 0.1μm to 20μm with an aspect ratio greater than 2. As shown in FIG. 2D, the type of micro-structured features 102 illustrated is a cavity. It should be noted that the spacing between two adjacent first pores 101 refers to the distance between the centers of two adjacent first pores 101, as denoted by $s_p$ in FIG. 2B.

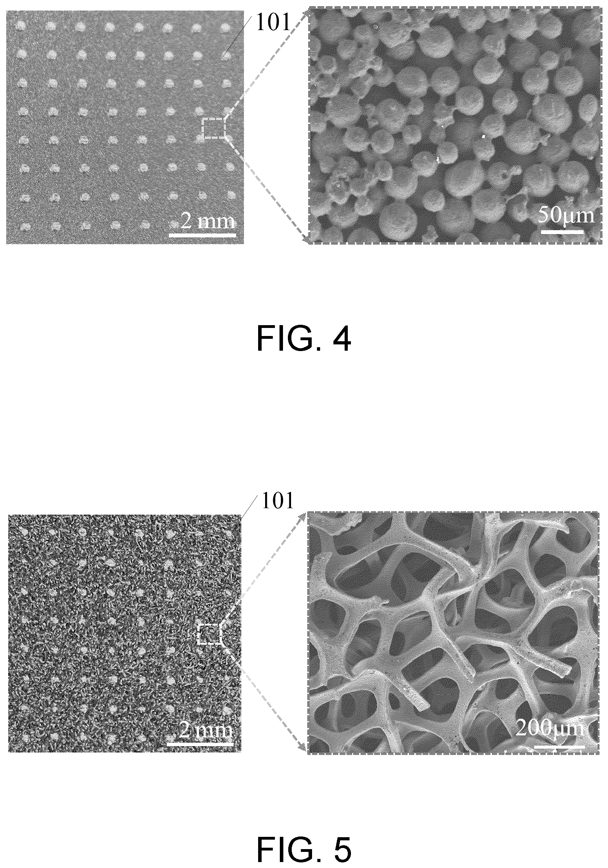

In some embodiments, the pore size of the second pores 103 may range from 10μm to 500μm, as denoted by $w_m$ in FIG. 2C, the diameter or width of the solid skeleton of the surface structure may range from 20μm to 100μm, as denoted by $d_m$ in FIG. 2C (the figure shows a micro-perforated copper mesh as an example), where the figure refers to the diameter range of the copper wire. If the surface structure is a copper powder, it refers to the diameter range of the copper powder, FIG. 4 shows an top-view SEM image of the micro-perforated copper powder; if the surface structure is a copper foam, it refers to the width range of the copper foam skeleton, FIG. 5 shows an top-view SEM image of the micro-perforated copper foam.

The surface structure for enhancing boiling heat transfer disclosed in the embodiments of the present disclosure is not limited to multi-layer mesh, sintered powder, and metal foam, but may also include other structural types or combinations of these types, such as grooves, micro-pillar arrays, electrodeposited porous structures, etc.

FIG. 2 shows a top-view SEM image of an example micro-perforated copper mesh according to some embodiments, FIG. 4 shows a top-view SEM image of an example micro-perforated copper powder according to some embodiments, and FIG. 5 shows a top-view SEM image of the micro-perforated copper foam according to some embodiments. In these examples, the array arrangement of the first pores 101 in these structures is all square array, the pore size of the first pores 101 is all $300\mu m$, the pore spacing is all $900\mu m$, the total thickness of the surface structure for enhancing boiling heat transfer is all $400\mu m$, and the width of the micro-structured features 102 is all $1\ \mu m$ to $10\mu m$. For the example micro-perforated copper mesh, the diameter of the copper wire is $60\mu m$, the spacing between the center lines of the copper wires is $170\mu m$, the number of mesh layers is 4, the surface roughness is $0.27\mu m$, and the static contact angle with respect to deionized water is $20.3°$; for the example micro-perforated copper powder, the average diameter of the copper powder is $50\mu m$, and the average porosity is 43%; for the example micro-perforated copper foam, the average pore size of the copper foam is $170\mu m$, and the average porosity is 85%.

In some embodiments, the materials for fabricating the surface structure for enhancing boiling heat transfer and the heat transfer substrate may not only be copper, but may also be other materials such as brass, bronze, aluminum, silicon, titanium, stainless steel, etc.

To verify the effect of enhancing heat transfer performance of the surface structure for enhancing boiling heat transfer disclosed in the embodiments of the present disclosure, the inventors took liquid film boiling as an example and conducted verification through experiments. In the experiments, the arrangement of multiple first pores 101 was in an array arrangement (hereinafter referred to as perforated array), including two types: square array and hexagonal array, and the first pores 101 were through-hole pores as an example for illustration.

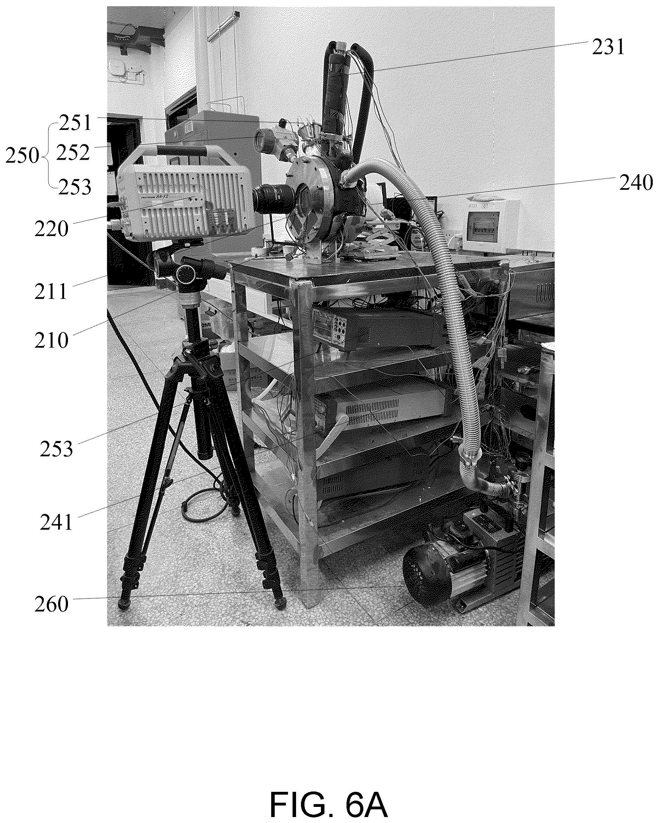

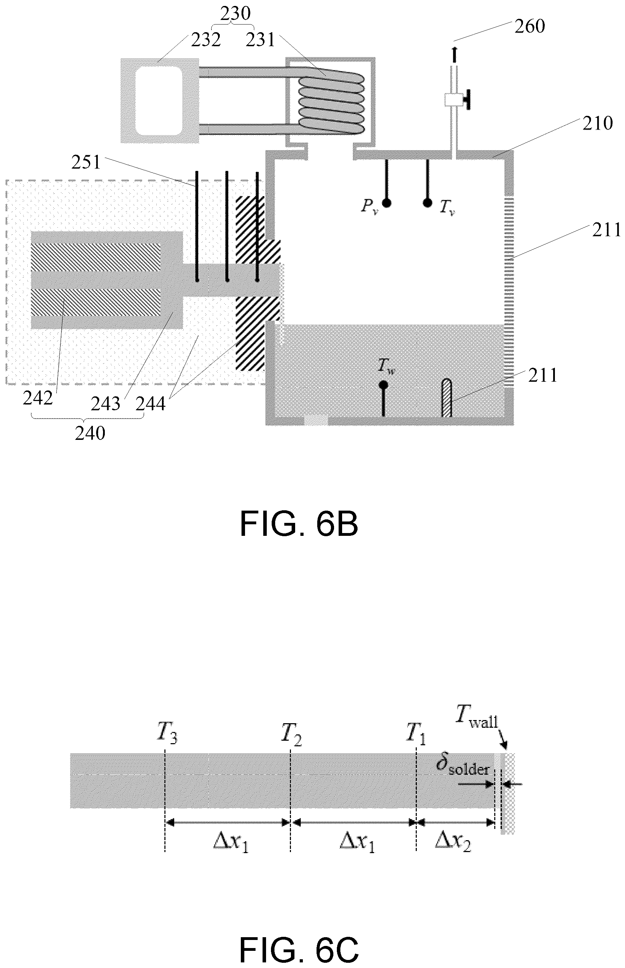

FIG. 6A and FIG. 6B are a photograph and a schematic of the liquid film boiling experimental setup, respectively. The liquid film boiling experimental setup includes a liquid film boiling chamber 210, a camera system, a cooling circulation loop 230, a heating system 240, and a data measurement system 250.

The liquid film boiling chamber 210 is a sealed chamber with an viewing window 211. The liquid film boiling chamber 210 is equipped with a cartridge heater, a thermocouple 251, a PID control system, and a vacuum pump 260, to ensure that the working fluid inside the liquid film boiling chamber 210 is maintained at a preset temperature and pressure.

The camera system includes a high-speed camera 220, which may perform time-lapse photography of the boiling phenomenon of the surface structure (hereinafter referred to as the test sample) for enhancing boiling heat transfer through the viewing window 211; the cooling circulation loop 230 includes a condenser 231 and a chiller 232. The condenser 231 uses a spiral tube condenser, with deionized water as the working fluid, to provide a cold source for the liquid film boiling chamber.

The heating system 240 includes a DC power supply 241, a cylindrical heater 242, a heating block 243, and an insulation material 244. The insulation material 244 may be thermal insulation cotton or polyether ether ketone (PEEK). The DC power supply 241 provides power to the cylindrical heater 242, and the insulation material 244 assists in thermal insulation to ensure that the test sample in the experiment obtains sufficient heating power. The heating block 243 connected to the test sample may have two cross-sectional areas: 5mm×5mm and 10mm×10mm. The data measurement system 250 includes thermocouples 251, a pressure transducer 252, and a data acquisition system 253, configured for recording experimental data.

FIG. 6C is a schematic showing the arrangement of thermocouples 251 inside the heating block 243 in the liquid film boiling setup provided in the embodiments of the present disclosure. Each test sample is connected to the heating block 243 by solder. Three K-type thermocouples 251 are inserted into diameter holes of 1mm at intervals of 10mm. The first thermocouple $T_1$ is 5mm from the top of the heating block 243. In the experiment, the electric power input to the cylindrical heater 242 is adjusted through the DC power supply 241 to change the heat flux inside the heating block 243. The temperature data of the three thermocouples $T_1$, $T_2$, and $T_3$ are recorded by the data acquisition system 253. Each electric power is maintained for more than 20 minutes until all temperature changes are less than 0.2K within 10 minutes, reaching a steady state. Then, these temperature data are configured to calculate the heat flux and surface temperature of the test sample. According to the Taylor's backward series approximation, the heat flux q" provided to the test sample may be calculated as: $q'' = k_{Cu}[2(T_2-T_1)/\Delta x_{12} -(T_3 -T_1)/\Delta x_{13}]$, wherein $k_{Cu}$ is the thermal conductivity of copper (using copper as the material of the test sample in the experiment as an example), $\Delta x_{ij}$ is the distance between thermocouples $T_i$ and $T_j$. The surface superheat $\Delta T$, which is the temperature difference between the wall temperature of the test sample ($T_{wall}$) and the saturated vapor temperature ($T_v$), is extrapolated from the linear temperature gradient in the copper block: $\Delta T = T_w - T_v = T_1 - q''(\delta_{Cu} / k_{Cu} + \delta_{solder} / k_{solder} ) - T_v$, wherein $\delta_{Cu}$ is the distance between the top thermocouple $T_1$ and the top surface of the copper block, $\delta_{solder}$ and $k_{solder}$ are the thickness and thermal conductivity of the solder, respectively. The heat transfer coefficient h is calculated by the following equation: $h = q'' / \Delta T$. The uncertainties in heat flux, superheat, and heat transfer coefficient may all be determined using the standard error propagation equation:

$$\sigma(Y) = \sqrt{\sum_{1}^{N} \left[ (\partial Y / \partial a_i) \sigma(a_i) \right]^2}$$ . wherein Y is the calculated parameter, $a_i$ is the measured parameter, and $\sigma$ is the uncertainty. The calculation results show that the uncertainty of pressure P is $\pm 0.075\%$, the uncertainty of temperature T is $\pm 0.1K$, the uncertainty of distance measurement $\Delta x$ is $\pm 0.1mm$, the uncertainty of solder thickness $\delta_{solder}$ is $\pm 0.01mm$, the uncertainty of superheat $\Delta T$ is $\pm 12\%$, the uncertainty of heat flux q" is $\pm 1\%$, and the uncertainty of heat transfer coefficient h is $\pm 12\%$.

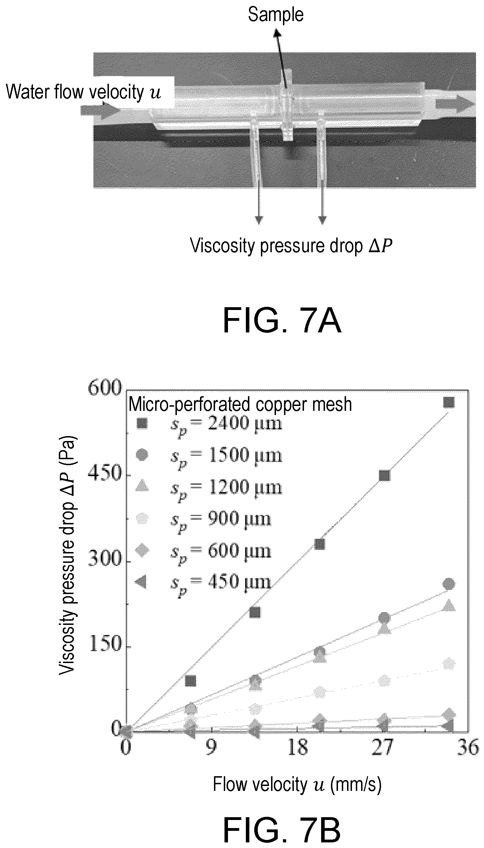

First, the inventors experimentally measured the permeability in the through-thickness direction of three types of surface structures: micro-perforated copper mesh, micro-perforated copper powder, and micro-perforated copper foam. FIG. 7A is a photograph of the experimental setup for measurement, mainly including two PMMA tubes with an inner diameter of 10 millimeters. The permeability is calculated by controlling the water flow velocity and measuring the pressure difference of the liquid (deionized water) between the two PMMA tube openings. According to Darcy's law, the permeability in the through-thickness direction may then be calculated using the following formula: $K_{wz} = \mu_l u_l \delta_w / \Delta P_w$, wherein $\Delta P_w$ represents the pressure difference, $u_l$ denotes the water flow velocity, and $\delta_w$ signifies the thickness of the sample. As shown in FIG. 7B to FIG. 7D, for different types of surface structures for enhancing boiling heat transfer, $K_{wz}$ is obtained through linear fitting of the pressure difference with liquid flow velocity, namely $\Delta P_w = \mu_l \delta_w / K_{wz}) u_l$. FIG. 7B, for micro-perforated copper meshes, under the same water flow velocity, the viscous pressure difference tends to increase as the perforation spacing increases. For perforated arrays with the same perforation spacing, the viscous pressure difference tends to increase as the water flow velocity increases.

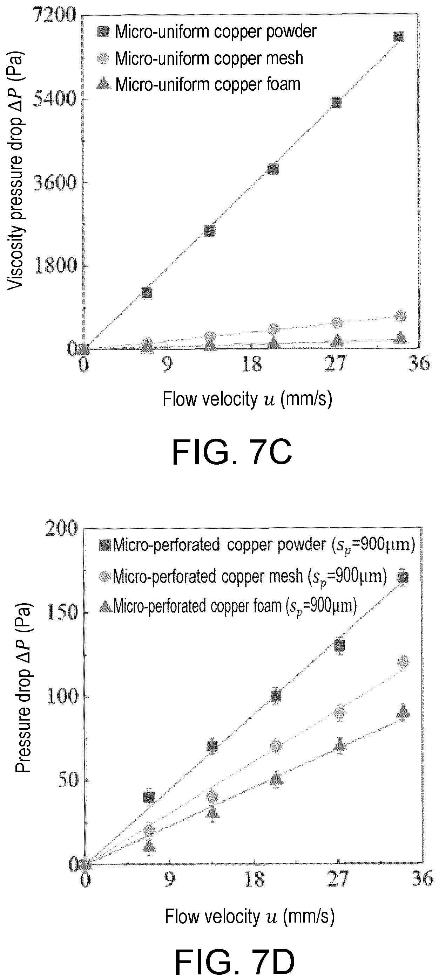

FIG. 7C shows the pressure difference in the through-thickness direction as a function of water flow velocity for micro-uniform surface structures with different wicking structures: micro-uniform copper mesh, micro-uniform copper powder, and micro-uniform copper foam. As can be seen from the figure, the viscous pressure difference of micro-uniform copper powder shows a more obvious increasing trend with the change of water flow velocity, followed by micro-uniform copper mesh, and the increasing trend of micro-uniform copper foam is the smallest. That is, compared with the three types of surface structures, copper powder has greater water flow resistance compared to the other two types.

FIG. 7D shows the pressure difference in the through-thickness direction as a function of water flow velocity for micro-perforated surface structures with different wicking structures: micro-perforated copper mesh, micro-perforated copper powder, and micro-perforated copper foam respectively. As can be seen from the figure, the viscous pressure difference of micro-perforated copper powder shows a more obvious increasing trend with the change of water flow velocity, followed by micro-perforated copper mesh, and the increasing trend of perforated copper foam is the smallest, which is consistent with the changing trend of uniform surface structures without perforated arrays. Meanwhile, from FIG. 7C to FIG. 7D, it can be seen that the surface structures for enhancing boiling heat transfer with perforated arrays have significantly reduced viscous pressure difference values compared to those without perforated arrays. For example, at a water flow velocity of 27mm/s, the viscous pressure difference in the thickness direction of water flowing through micro-uniform copper powder is about 5400Pa, while the viscous pressure difference in the through-thickness direction of water flowing through micro-perforated copper powder is about 130Pa. It can be seen that the viscous pressure difference value is significantly reduced when water flows through the surface structure for enhancing boiling heat transfer with perforated arrays, which may verify that the perforated arrays of the surface structure for enhancing boiling heat transfer may provide low-resistance flow channels. Therefore, it is possible to allow bubbles to departure smoothly, and the direction of bubble departure is consistent with the direction of heat dissipation, thus improving heat transfer efficiency.

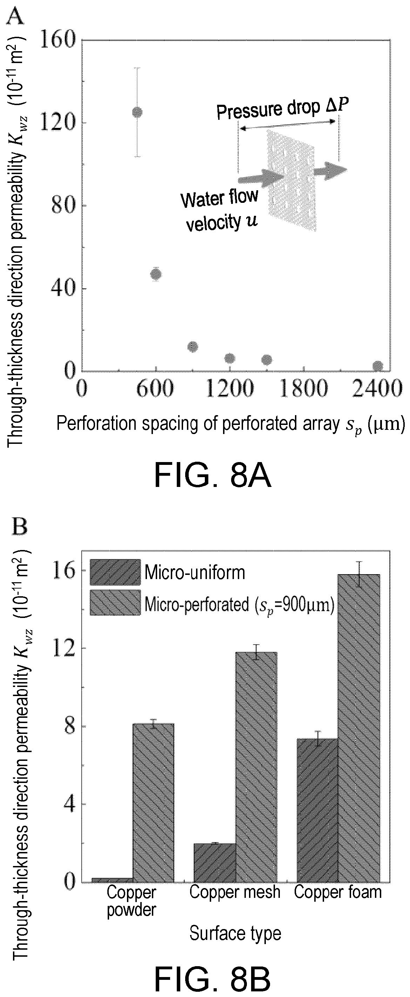

As shown in FIG. 8A, as the spacing ($s_p$) of the perforated array decreases, the quantity of the first pores 101 in the perforated array increases, and $K_{wz}$ increases significantly. FIG. 8B compares the $K_{wz}$ of different types of surface structures for enhancing boiling heat transfer. All surface structures with the first pores 101 (shown as perforated in the figure) have larger $K_{wz}$ compared to surface structures without the first pores 101 (shown as uniform in the figure), which is due to their expanded flow channels.

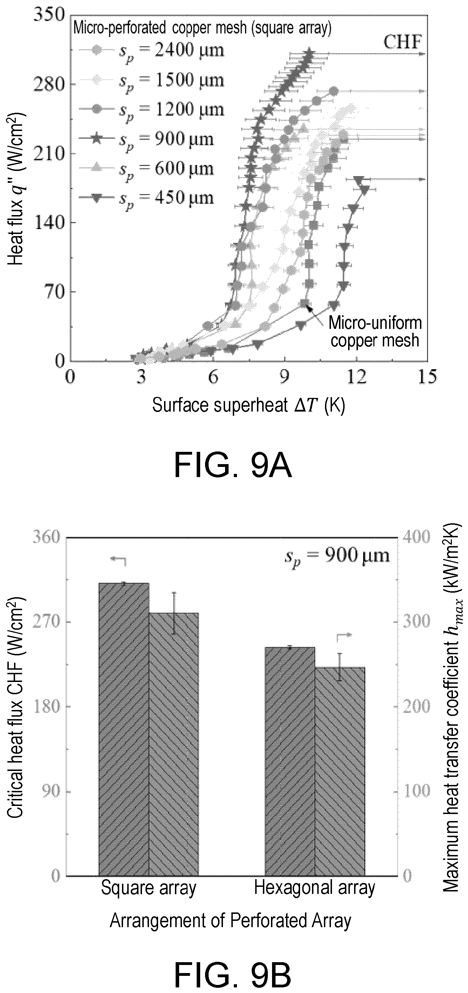

FIG. 9A shows the heat transfer curve of liquid film boiling on the surfaces of micro-perforated copper meshes with different perforation distances (the heating area of the heating block 243 is 10mm×10mm). The figure also shows the liquid film boiling curve of micro-uniform copper mesh without perforated arrays. As can be seen from the figure, for micro-perforated copper meshes with pore spacing greater than 600μm, the CHF and HTC are significantly enhanced. For example, for the micro-perforated copper mesh with a pore spacing of 900μm, at a superheat of 10.1K, its CHF reaches 311.2W/cm², and the maximum heat transfer coefficient is 310.4kW/(m²K), which are 38.4% and 58.5% higher than those of micro-uniform copper mesh, respectively. It can be seen that after setting up the perforated array, the CHF and HTC of liquid film boiling are significantly enhanced, that is, the surface structure for enhancing boiling heat transfer disclosed in the embodiments of present disclosure has significantly enhanced heat transfer performance.

For the two types of perforated arrays, square array and hexagonal array, the inventors conducted experimental verification respectively, as shown in FIG. 9B. The figure shows the liquid film boiling heat transfer performance of surfaces of micro-perforated copper meshes with square array and hexagonal array types under the heating area of 10mm×10mm of the heating block 243. In the experiment, the diameter of the first pores 101 was $300\mu m$, and the pore spacing was $900\mu m$ for both types. When the type of perforated array changed from square array to hexagonal array, the CHF on the 10mm×10mm heating area decreased from $311.2W/cm^2$ to $243.2W/cm^2$, and the maximum heat transfer coefficient reduced from $310.4kW/(m^2K)$ to $245kW/(m^2K)$. It can be seen that the square array has a better effect on enhancing heat transfer compared to the hexagonal array.

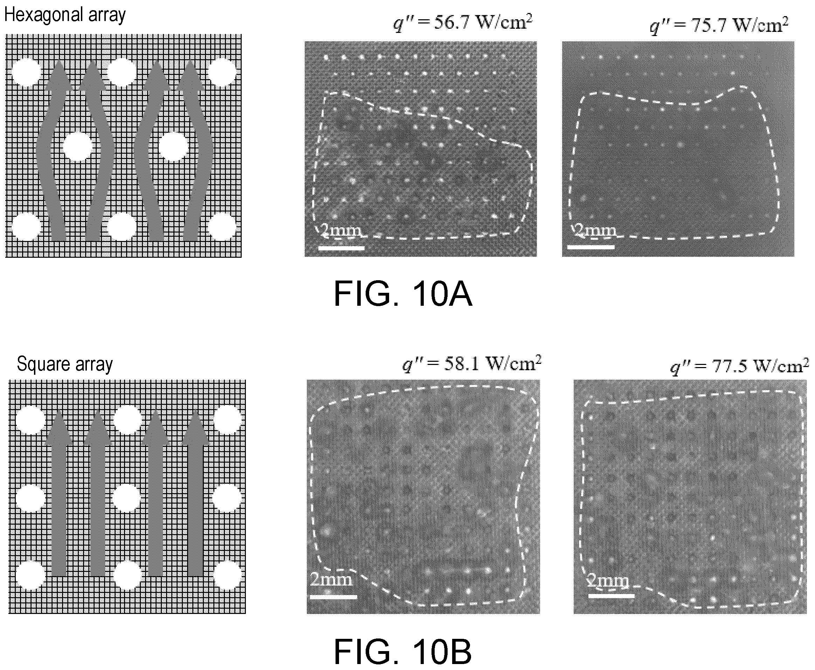

FIG. 10A to FIG. 10B show dynamic images of bubbles on surfaces of micro-perforated copper meshes with square array and hexagonal array types in the heat flux ranging from $56.7W/cm^2$ to $77.5W/cm^2$. The arrows in the figures indicate the liquid transport paths, and the dashed lines indicate the boiling regions. As can be seen from the figures, the liquid supply on the surface of micro-perforated copper mesh with square array is more sufficient, forming orderly liquid transport paths and larger boiling regions. The perforations in the hexagonal array increase the resistance to liquid flow, resulting in relatively tortuous liquid transport paths, which hinder the flow of liquid within the copper mesh, thus leading to lower CHF and HTC.

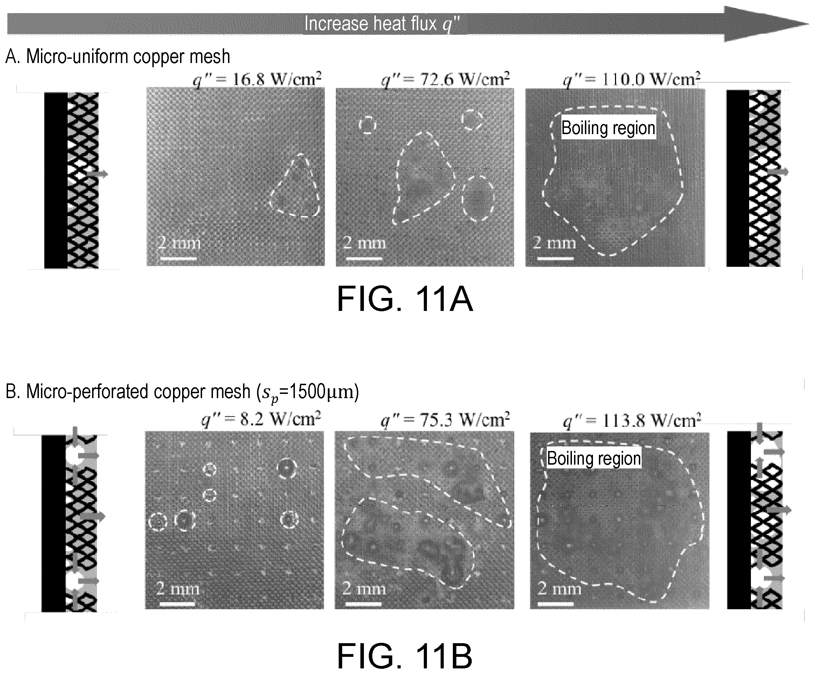

The inventors conducted experiments on the boiling phenomena of micro-uniform copper mesh and micro-perforated copper mesh, respectively (with pore distances of $1500\mu m$ and $900\mu m$ respectively) in the heat flux ranging from $6.1W/cm^2$ to $117.1 W/cm^2$. As can be seen from FIG. 11A, for the micro-uniform copper mesh, bubble nucleation is activated at a heat flux density of $16.8W/cm^2$ and a superheat of 5.3K, i.e., bubbles begin to form under these parameters. With the increase of heat flux, the number of bubble nucleation sites increases, and the boiling region gradually expands. The region circled by dashed lines in the figure indicates the boiling regions, which are labeled accordingly. At higher heat flux ($110.0W/cm^2$), the number of bubbles increases, and bubbles tend to coalesce to form large bubbles. These larger bubbles hinder the flow of liquid and the wetting of the heated surface, which may lead to local dry-out and trigger CHF.

FIG. 11B shows the micro-perforated copper mesh with a pore spacing of $1500\mu m$ in the perforated array. Due to the arrangement of multiple micro-structured features 102, bubble nucleation is triggered at a heat flux of $8.2W/cm^2$. As the heat flux increases, multiple bubbles departure simultaneously from the first pores 101 and second pores 103 of the perforated array. When the heat flux exceeds $113.8W/cm^2$, bubbles coalesce within the copper mesh, and vapor fills large areas of the copper mesh, hindering liquid flow, thereby triggering the CHF.

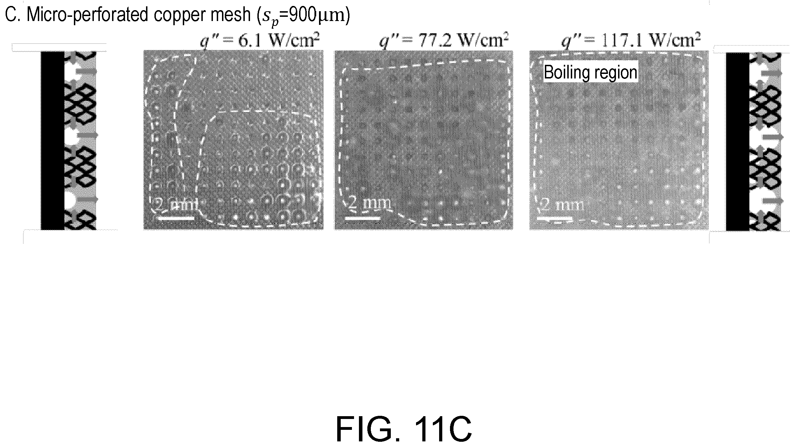

FIG. 11C shows the boiling phenomenon on the surface of the micro-perforated copper mesh with a pore spacing of $900\mu m$ in the perforated array. Bubble nucleation is activated at a heat flux of $6.1W/cm^2$ and a superheat of 3.1K. In the heat flux ranging from $6.1W/cm^2$ to $117.1W/cm^2$, bubbles mainly departure from the first pores 101 of the perforated array, while liquid flows through the copper mesh to rewet the heated surface, allowing liquid and vapor transport to occur without interference, resulting in lower liquid-vapor flow resistance and faster liquid-vapor transport. From the above data, it can be seen that compared to the micro-uniform copper mesh, the micro-perforated copper mesh triggers bubble nucleation at a lower heat flux and has a higher CHF. This indicates that the arrangement of the perforated array and multiple micro-structured features 102 may promote bubble nucleation while facilitating bubble departure, improving heat transfer efficiency and enhancing heat transfer performance.

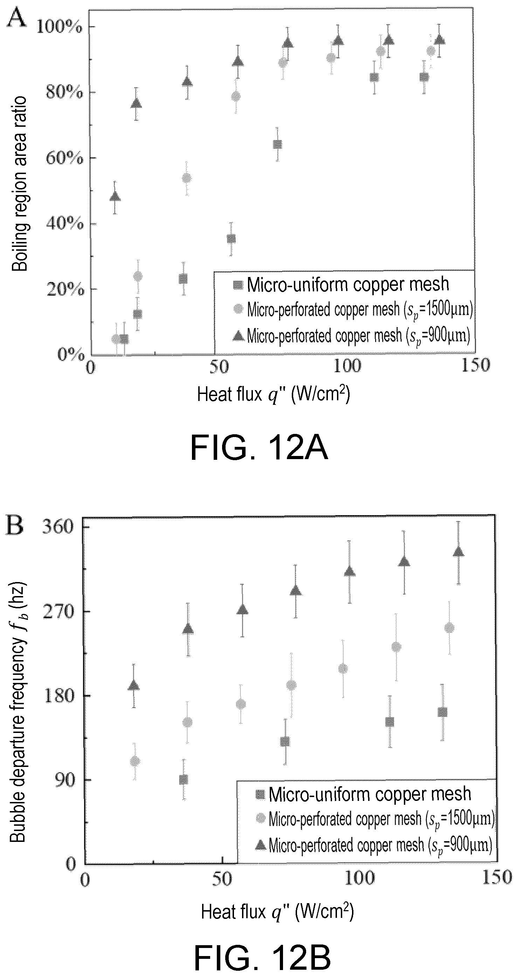

FIG. 12A to FIG. 12B show the boiling region area ratio (i.e., the ratio of bubble jetting region area to total heated area) and bubble departure frequency on the surfaces of micro-uniform copper mesh, micro-perforated copper mesh with $1500\mu m$ perforation spacing, and micro-perforated copper mesh with $900\mu m$ perforation spacing (three types of surface structures). The boiling region area ratio and bubble departure frequency are important parameters describing boiling heat transfer characteristics. Bubble nucleation increases with increasing heat flux, and the boiling region area ratio of the three types of surface structures gradually increases with heat flux. Micro-perforated copper meshes have larger boiling region areas than micro-uniform copper mesh. As shown in FIG. 12A, when the heat flux exceeds $50W/cm^2$, the boiling region area ratio of the micro-perforated copper mesh with $900\mu m$ pore spacing rapidly exceeds 90%, indicating that more liquid-vapor interfaces on this surface participate in phase change heat transfer, thereby enhancing the surface heat transfer coefficient. FIG. 12B shows the variation of bubble departure frequency with heat flux for the three types of surface structures. The bubble departure frequency continuously increases with increasing heat flux. Due to the reduced bubble escape resistance, the bubble departure frequency of micro-perforated copper meshes is higher than that of micro-uniform copper mesh. Among the three types of surface structures, the micro-perforated copper mesh with pore spacing of $900\mu m$ has the highest bubble departure frequency, about 310Hz, which is more than twice that of the micro-uniform copper mesh (about 130Hz). It can be seen that micro-perforated copper meshes exhibit enhanced phase change heat transfer phenomena throughout the entire heat flux range, including larger boiling regions and faster bubble departure.

Therefore, the arrangement of the perforated array significantly enhances the heat transfer performance.

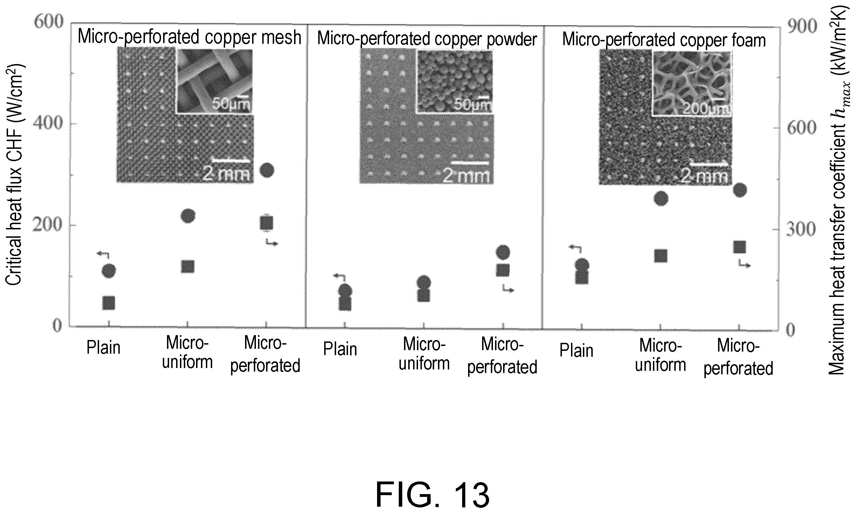

FIG. 13 shows the liquid film boiling heat transfer characteristics of different types of surface structures when the perforated array is a square array. The tested surface structures include copper mesh, sintered copper powder, and copper foam. All test perforated surface structures have first pores 101 with a diameter of $300\mu m$ and a pore spacing of $900\mu m$. In the figure, "plain" refers to plain uniform surface structures with only second pores 103, "micro-uniform" refers to surface structures with second pores 103 and micro-structured features 102, and "micro-perforated" refers to micro-perforated surface structures with second pores 103, micro-structured features 102, and first pores 101. Compared with plain uniform surface structures, various micro-uniform surface structures show significant improvements in both CHF and heat transfer HTC, which is due to the enhanced liquid wicking capability. In addition, compared with micro-uniform surface structures, micro-perforated surface structures further enhance CHF and HTC. Specifically, compared to micro-uniform surface structures, micro-perforated copper mesh and micro-perforated copper powder enhance CHF by 66.1% and 66.8%, and HTC by 77.3% and 90.2%, respectively. This is mainly because the first pores 101 reduce the vapor flow resistance and promote bubble departure. However, for copper foam, micro-perforated copper foam shows only a 6.8% increase in CHF and a 13.2% increase in HTC compared to micro-uniform copper foam. This difference is due to the fact that micro-uniform copper foam with already has a high porosity (about 82%) and large micropores (about $200\mu m$), resulting in low resistance to vapor flow within the micro-uniform copper foam. The test samples in the embodiment may be used for two-phase heat sinks, such as thermal ground planes.

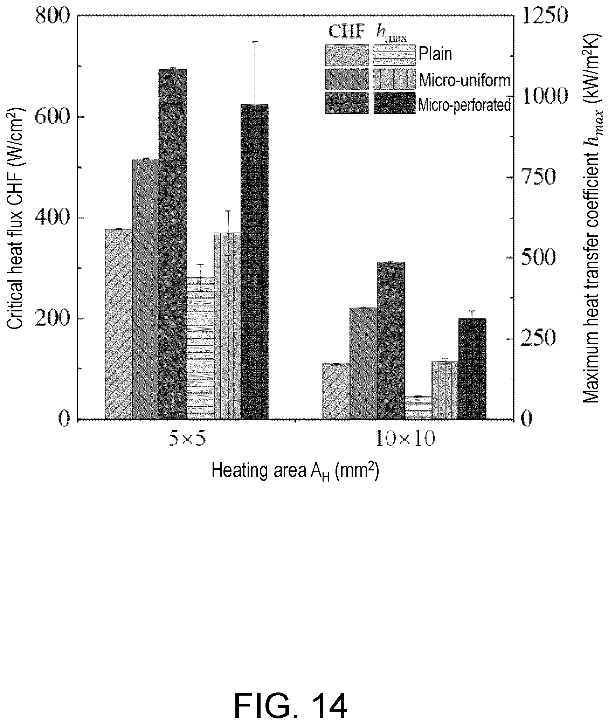

FIG. 14 shows the comparison between the measurement results of different surface structures (using micro copper mesh structure as an example) under two heating areas of 5mm×5mm and 10mm×10mm on the heating block 243. As shown in the figure, the micro-perforated copper mesh (abbreviated as "micro-perforated" in the figure) significantly increases CHF and HTC compared to the other two structures under different heating areas. By reducing the area of the heating region, the flow distance of the liquid from the bottom edge to the top edge may be significantly reduced, which helps to lower the liquid flow resistance and improve the liquid wicking velocity, thereby enhancing the CHF and HTC of the copper mesh surface. On the small heating area of 5mm×5mm, the CHF of the perforated copper mesh surface reaches $693.1W/cm^2$, while the HTC is as high as $974.9kW/(m^2K)$.

From the various experiments conducted by the inventors, it may be seen that the configuration of the micro-structured features 102 increases the effective bubble nucleation sites for boiling, facilitating the incipience of liquid film boiling. The configuration of the micro-structured features 102 also improves the surface wettability, providing permeable liquid channels with high capillary force and low resistance, allowing passive, high-flux liquid wicking to rewet the heated surface. The configuration of the perforated array (multiple first pores 101) reduces the vapor flow resistance, which may promote bubble departure, thereby improving heat transfer efficiency and enhancing heat transfer performance.

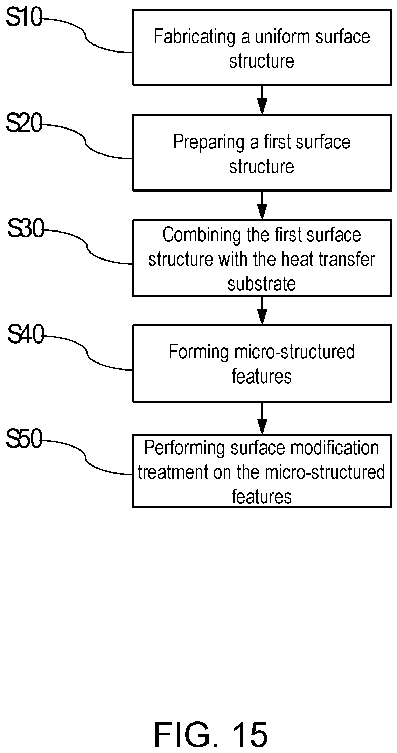

FIG. 15 illustrates a method for fabricating the surface structure for enhancing boiling heat transfer of the above embodiments, comprising:

S10. Preparing a uniform surface structure;
The uniform surface structure includes second pores 103;
S20. Preparing a first surface structure;
Perforating the uniform surface structure to form first pores 101. Specifically, the uniform surface structure may be perforated by mechanical processing or laser perforation.

S30. Combining the first surface structure with the heat transfer substrate 110;
The first surface structure is combined with the heat transfer substrate 110 to form a combination of the heat transfer substrate 110 and the first surface structure, hereinafter referred to as the combination. In an embodiment, the first surface structure may be combined with the heat transfer substrate 110 by vacuum diffusion bonding, diffusion bonding with protective gas, or electroplating, or other ways may be adopted.

S40. Preparing microscale structures 102;
The surface of the combination of the heat transfer substrate 110 and the first surface structure is treated using an etching method to form multiple microscale structures 102 on the first surface structure and the heat transfer substrate 110. In an embodiment, the surface may be etched by chemical etching, sandblasting, electroplating, or mechanical processing, or other ways may be adopted.

S50. Performing surface modification treatment on the microscale structures 102;
Hydrophilic or hydrophobic surface modification treatment is performed on at least a portion of the microscale structures 102. In an embodiment, the methods for surface modification treatment include, but are not limited to, plasma modification, surface coating techniques, and surface grafting modification.

Taking laser perforation as an example, in some embodiments, the method for preparing a first surface structure (Block S20) comprising:

S21. Introducing the perforation array design pattern into the laser drilling system, analysing and processing the structural model of the perforation array (the structural model of the perforation array may be designed and drawn using 2D drawing software AutoCAD) to obtain the laser scanning sequence;
S22. Adjusting the laser frequency and power of the laser drilling system to perforate the uniform surface structure, for example, using nanosecond laser perforation technology, exposing the structural pattern of a two-dimensional perforation array on the uniform surface structure to be prepared according to the laser scanning sequence, thereby fabricating the perforated surface structure;
S23. Repeating the above process on different types of uniform surface structures to form perforation arrays on different types of uniform surface structures.

In step S22, a fixture may be used to secure the uniform surface structure on the laser processing control platform, reducing the vibration of the uniform surface structure, thereby making the perforation of the uniform surface structure more precisely conform to the modeling pattern of the two-dimensional perforation array.

It should be noted that various types of lasers may be used for the laser perforation technology here, such as femtosecond laser, picosecond laser, nanosecond laser, etc. Different types of lasers will leave different structural morphologies on the surface after cutting the uniform surface structure. For example, using a nanosecond laser may leave a relatively rough metal melting structure on the uniform surface structure. Therefore, in actual laser perforation, the specific laser type to be used may be selected according to the actual requirement.

Taking mechanical drilling as an example, in some embodiments, the method for preparing a first surface structure (Block S20) comprising: using a manual lathe, CNC lathe, or machining center to perform drilling on the uniform surface structure to obtain the perforated surface structure according to the structural model of the designed perforation array.

In some embodiments, the method for combining the first surface structure with the substrate 110 (Block S30) comprising:

S31. Using a fixture to stack the heat transfer substrate 110 and the first surface structure together to form a combination;
S32. Placing the combination into a high-temperature vacuum oven for sintering to bond the first surface structure to the surface of the heat transfer substrate 110, forming a combination of the two.

In some embodiments, before Block S30, there is also a pre-treatment step S20', which specifically includes the following steps:

S21'. Polishing the surface of the heat transfer substrate 110;
S22'. Cleaning the polished heat transfer substrate 110 and the first surface structure.

In some embodiments, the first surface structure and the polished heat transfer substrate 110 are cleaned sequentially in an ultrasonic cleaning bath using a degreasing solvent, an alcohol solvent, an acidic solution, and deionized water. The degreasing solvent is utilized to clean oil stains on the surfaces of the heat transfer substrate 110 and the first surface structure; the alcohol solvent is utilized to clean the residual degreasing solvent on the surfaces of the heat transfer substrate 110 and the first surface structure; the acidic solution is utilized to remove oxides, such as copper oxide, from the surfaces of the heat transfer substrate 110 and the first surface structure; and the deionized water is utilized to wash away the residual acidic solution. During the above cleaning process, the heat transfer substrate 110 and the first surface structure may be immersed in the cleaning reagents for 3 to 20 minutes, and the mass percentage of dilute sulfuric acid may be selected as 5%.

In some embodiments, various types of degreasing solvents, alcohol solvents, and acidic solvents may be used. For example, the degreasing solvent may be acetone, toluene, or ethyl acetate; the alcohol solvent may be anhydrous ethanol or isopropanol; the acidic solvent may be dilute sulfuric acid with a mass percentage of 5% or a 2M dilute hydrochloric acid solution (containing 2 moles of hydrochloric acid molecules per liter of solution).

This embodiment of the present disclosure removes burrs, oil stains, and oxides present on the surface of the heat transfer substrate 110 through the pre-treatment step S20', allowing the first surface structure to bond more tightly to the surface of the heat transfer substrate 110.

In some embodiments, Block S40 is achieved through a chemical etching method, comprising:

S41. Preparing an oxide structure by immersing the combination in a hot alkaline chemical solution or a strong oxidizing solution to form an oxide structure;
S42. Removing the oxide structure by using an acidic solvent to remove the oxide structure on the surface of the combination and form micro-structured features 102 on the surface.

There are multiple methods for chemically etching the combination using a hot alkaline solution or a strong oxidizing solution. For example, the combination may be immersed in an alkaline solution mixed with $NaClO_2$, $NaOH$, $Na_3PO_4 \cdot 12H_2O$, and deionized water in a ratio of 3.75:5:10:100wt% at a temperature of 60°C to 90°C for 5 minutes to 50 minutes; or the combination may be immersed in a 30% $H_2O_2$ solution at room temperature for 3 hours to 8 hours; or the combination may be immersed in a combined solution of 2.5M NaOH and 0.1M $(NH_4)_2S_2O_8$ at a temperature of 5°C to 85°C for 5 minutes to 30 minutes. These methods may all allow an oxide structure to be formed on the surface of the first surface structure and the heat transfer substrate 110.

In some embodiments, there are multiple methods for removing the oxide structure on the surface using an acidic solution. For example, dilute sulfuric acid with a mass percentage of 5% or a 2M dilute hydrochloric acid solution may be used for removal of the oxide structure.

It should be noted that the above descriptions of the degreasing solvent, alcohol solvent, alkaline solution, strong oxidizing solution, chemical oxidation reaction temperature, chemical oxidation reaction duration, mass percentage of dilute sulfuric acid, and molar percentage of dilute hydrochloric acid are only examples in this embodiment of the present disclosure and are not intended as the sole limitation of this embodiment of the present disclosure.

The method for fabricating the surface structure for enhancing boiling heat transfer disclosed in this embodiment of the present disclosure has simple steps, reasonable design, is easy to implement, has high operability, is convenient for scale production, and has important practical value and significance for promotion.

It should be noted that each embodiment in this specification is described in a progressive manner, with each embodiment focusing on the differences from other embodiments. For the same or similar parts among the various embodiments, mutual references can be made.

As shown in the present disclosure and the claims, unless the context clearly suggests otherwise, the words "a", "an", "the", and/or "said" are not specifically referring to the singular, but may also include the plural. Generally speaking, the terms "include" and "comprise" only indicate the inclusion of explicitly identified steps and elements, and these steps and elements do not constitute an exclusive list. The method or device may also include other steps or elements. An element defined by the statement "including a..." does not exclude the existence of additional identical elements in the process, method, article, or apparatus that includes the element.

In the following, the terms "first" and "second" are used only for descriptive purposes and cannot be understood as indicating or implying relative importance or implicitly specifying the number of technical features indicated. Thus, features defined as "first" and "second" may explicitly or implicitly include one or more of these features.

Specific individual examples have been applied in this document to elucidate the principles and implementation methods of the present disclosure. The explanation of the above embodiments is only used to help understand the main idea of the present disclosure. It should be pointed out that for ordinary skilled persons in this technical field, without departing from the principles of the present disclosure, several improvements and modifications may also be made to the present disclosure, and these improvements and modifications also fall within the protection scope of the claims of the present disclosure.

**Claims**

1. A surface structure for enhancing boiling heat transfer, **characterized in that** the surface structure for enhancing boiling heat transfer is combined with a heat transfer substrate (110) and has a plurality of first pores (101) for bubble departure, a plurality of micro-structured features (102) for promoting bubble nucleation, and a plurality of second pores (103) for liquid wicking;

   pore sizes of the first pores (101) are greater than pore sizes of the second pores (103), and the pore sizes of the second pores (103) are greater than widths of the micro-structured features (102);
   quantities of the first pores (101), the microscale structures (102), and the second pores (103) are all plural.

2. The surface structure for enhancing boiling heat transfer according to claim 1, **characterized in that** an arrangement of the first pores (101) comprises at least one of an array arrangement or a random arrangement;
   the array arrangement comprises at least one of a square array, a rectangular array, a circular array, and a hexagon array arrangement.

3. The surface structure for enhancing boiling heat transfer according to claim 1, **characterized in that** cross-sectional shapes of the first pores (101) comprise at least one of triangle, rectangle, rhombus, pentagon, hexagon, circle, ellipse, and star; and/or, types of the micro-structured features (102) comprise at least one of cavities, pores, and gaps.

4. The surface structure for enhancing boiling heat transfer according to claim 1, **characterized in that** the first pores (101) are constructed as blind-hole pores on the surface structure for enhancing boiling heat transfer; or,

   the first pores (101) are constructed as through-hole pores on the surface structure for enhancing boiling heat transfer; or,
   portions of the first pores (101) are constructed as blind-hole pores on the surface structure for enhancing boiling heat transfer, while the remaining first pores (101) are constructed as through-hole pores on the surface structure for enhancing boiling heat transfer.

5. The surface structure for enhancing boiling heat transfer according to claim 4, **characterized in that** the first pores (101) at least comprise one of gradually expanding pores, gradually narrowing pores, and uniform pores.

6. The surface structure for enhancing boiling heat transfer according to claim 1, **characterized in that** the pore sizes of the first pores (101) are 10µm to 1000µm, and a spacing between two of the adjacent first pores (101) is 15µm to 5000µm; and/or, heights of the micro-structured features (102) are 0.1 µm to 20µm, and aspect ratios are greater than 2.

7. The surface structure for enhancing boiling heat transfer according to claim 1, **characterized in that** the pore sizes of the second pores (103) range from 10µm to 500µm, and a diameter or a width of a solid skeleton of the surface structure for enhancing boiling heat transfer ranges from 20µm to 100µm.

8. The surface structure for enhancing boiling heat transfer according to claim 1, **characterized in that** the surface structure for enhancing boiling heat transfer comprises one or more of multi-layer woven mesh, sintered powder, metal foam, grooves, micro-pillar arrays, and electrodeposited porous structures.

9. The surface structure for enhancing boiling heat transfer according to claim 1, **characterized in that** a material for fabricating the surface structure for enhancing boiling heat transfer comprises one or more of copper, brass, bronze, aluminum, silicon, titanium, and stainless steel; and/or, a material for fabricating the heat transfer substrate (110) comprises one of copper, brass, bronze, aluminum, silicon, titanium, and stainless steel.

10. A method for fabricating a surface structure for enhancing boiling heat transfer, used for fabricating the surface structure for enhancing boiling heat transfer according to any one of claims 1-9, **characterized by** comprising:

    fabricating a uniform surface structure, wherein the uniform surface structure comprises the second pores (103);
    preparing a first surface structure by perforating the uniform surface structure to form a first surface structure with the first pores (101);
    combining the first surface structure with the heat transfer substrate (110) to form a combined body of the two;
    forming the micro-structured features (102) by performing a treatment, using an etching technique, on a surface of the combined body of the heat transfer substrate (110) and the first surface structure to form the micro-structured features (102) on both the first surface structure and the heat transfer substrate (110);
    performing a surface modification treatment on the micro-structured features (102), by conducting a hydrophilic or hydrophobic surface modification treatment on at least a portion of the micro-structured features (102).

11. The method for preparing the surface structure for enhancing boiling heat transfer according to claim 10, **characterized by** further comprising a pretreatment step before a step of combining the first surface structure with the heat transfer substrate (110), wherein the pretreatment step specifically comprises:

    polishing a surface of the heat transfer substrate (110);
    cleaning the polished heat transfer substrate (110) and the first surface structure.

12. The method for preparing the surface structure for enhancing boiling heat transfer according to claim 10, **characterized in that** the etching technique at least comprises one of chemical etching, sandblasting, electroplating, and mechanical processing.

13. The method for preparing the surface structure for enhancing boiling heat transfer according to claim 10, **characterized in that** a technique for the hydrophilic or hydrophobic surface modification treatment at least comprises one of plasma modification, surface coating technique, and surface grafting modification.

FIG. 1

FIG. 2

FIG. 3

101

2 mm

50μm

# FIG. 4

101

2 mm

200μm

# FIG. 5

FIG. 6A

FIG. 6B

FIG. 6C

Sample

Water flow velocity $u$

Viscosity pressure drop $\Delta P$

FIG. 7A

FIG. 7B

FIG. 7C

FIG. 7D

A

FIG. 8A

B

FIG. 8B

FIG. 9A

FIG. 9B

Hexagonal array

$q'' = 56.7 \ \mathrm{W/cm^2}$

$q'' = 75.7 \ \mathrm{W/cm^2}$

2mm

2mm

FIG. 10A

Square array

$q'' = 58.1 \ \mathrm{W/cm^2}$

$q'' = 77.5 \ \mathrm{W/cm^2}$

2mm

2mm

FIG. 10B

EP 4 779 688 A1

Increase heat flux $q''$

A. Micro-uniform copper mesh

$q'' = 16.8 \ W/cm^2$     $q'' = 72.6 \ W/cm^2$     $q'' = 110.0 \ W/cm^2$

Boiling region

2 mm     2 mm     2 mm

# FIG. 11A

B. Micro-perforated copper mesh ($s_p$=1500μm)

$q'' = 8.2 \ W/cm^2$     $q'' = 75.3 \ W/cm^2$     $q'' = 113.8 \ W/cm^2$

Boiling region

2 mm     2 mm     2 mm

# FIG. 11B

EP 4 779 688 A1

C. Micro-perforated copper mesh ($s_p$=900μm)

$q'' = 6.1$ W/cm²     $q'' = 77.2$ W/cm²     $q'' = 117.1$ W/cm²

Boiling region

2 mm     2 mm     2 mm

FIG. 11C

FIG. 12A

FIG. 12B

FIG. 13

FIG. 14

S10 — Fabricating a uniform surface structure

S20 — Preparing a first surface structure

S30 — Combining the first surface structure with the heat transfer substrate

S40 — Forming micro-structured features

S50 — Performing surface modification treatment on the micro-structured features

# FIG. 15

## INTERNATIONAL SEARCH REPORT

| | International application No. |
|---|---|
| | **PCT/CN2024/129228** |

**A. CLASSIFICATION OF SUBJECT MATTER**

H01L23/427(2006.01)i; H01L23/367(2006.01)i; F28F13/18(2006.01)i; F28F13/06(2006.01)n

According to International Patent Classification (IPC) or to both national classification and IPC

**B. FIELDS SEARCHED**

Minimum documentation searched (classification system followed by classification symbols)

IPC:H01L23/-; F28F13/-

Documentation searched other than minimum documentation to the extent that such documents are included in the fields searched

Electronic data base consulted during the international search (name of data base and, where practicable, search terms used)

CNTXT, ENTXT, ENTXTC, VCN, DWPI, CNKI: 华中科技大学, 杨荣贵, 李鹏堃, 刘修良, 强化, 沸腾, 传热, 感热, 表面, 基板, 底板, 孔道, 微结构, 微尺寸, 微腔, 微通道, 微流道, 液体, 抽, 吸, 气泡, 汽泡, 脱离, 分离, 核, bubble?, blister?, micro, structure?, pass+, separat+, liquid+, fluid+.

**C. DOCUMENTS CONSIDERED TO BE RELEVANT**

| Category* | Citation of document, with indication, where appropriate, of the relevant passages | Relevant to claim No. |
|---|---|---|
| Y | US 2021131753 A1 (UNIVERSITY OF COLORADO DENVER) 06 May 2021 (2021-05-06) description, paragraphs 85-198 | 1-13 |
| Y | CN 117936479 A (NATIONAL UNIVERSITY OF DEFENSE TECHNOLOGY) 26 April 2024 (2024-04-26) description, paragraphs 27-45, and figures 1-3 | 1-13 |
| A | CN 116182614 A (CENTRAL SOUTH UNIVERSITY) 30 May 2023 (2023-05-30) entire document | 1-13 |
| A | CN 101589287 A (NEC CORP.) 25 November 2009 (2009-11-25) entire document | 1-13 |
| A | US 2022397376 A1 (DAMORPHE) 15 December 2022 (2022-12-15) entire document | 1-13 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **02 April 2025** | **02 April 2025** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/129228**

| Patent document cited in search report | | | Publication date (day/month/year) | Patent family member(s) | | | Publication date (day/month/year) |
|---|---|---|---|---|---|---|---|
| US | 2021131753 | A1 | 06 May 2021 | US | 11306983 | B2 | 19 April 2022 |
| | | | | US | 2024133643 | A1 | 25 April 2024 |
| | | | | US | 12188732 | B2 | 07 January 2025 |
| | | | | WO | 2019241223 | A1 | 19 December 2019 |
| | | | | EP | 3803247 | A1 | 14 April 2021 |
| | | | | EP | 3803247 | A4 | 23 March 2022 |
| | | | | US | 2022221233 | A1 | 14 July 2022 |
| | | | | US | 11898807 | B2 | 13 February 2024 |
| CN | 117936479 | A | 26 April 2024 | None | | | |
| CN | 116182614 | A | 30 May 2023 | None | | | |
| CN | 101589287 | A | 25 November 2009 | US | 2010012299 | A1 | 21 January 2010 |
| | | | | WO | 2008090726 | A1 | 31 July 2008 |
| | | | | JPWO | 2008090726 | A1 | 13 May 2010 |
| US | 2022397376 | A1 | 15 December 2022 | US | 2024133662 | A1 | 25 April 2024 |
| | | | | US | 2024230288 | A9 | 11 July 2024 |

Form PCT/ISA/210 (patent family annex) (July 2022)